# EUROPEAN PATENT APPLICATION

(11) **EP 3 454 484 A1**
(43) Date of publication of application: **13.03.2019**
(21) Application number: 17189753.1
(22) Date of filing: 07.09.2017
(51) Int. Cl.: H04B 10/40, H01S 5/40, H04B 10/64

(54) **TUNABLE TRANSCEIVER FOR OPTICAL ACCESS**

(71) Applicant: Nokia Solutions and Networks Oy, 02610 Espoo (FI)
(72) Inventor: BRENOT, Romain, 75014 Paris (FR); HERON, Ronald, Ottawa, Ontario K2K 2E6 (CA)
(74) Representative: Novagraaf Technologies

(57) **Abstract**

The present invention relates to an optical transceiver for passive optical network comprising:
- an upstream laser emitting at the wavelength λ_{US}; and
- a receiver comprising a reference laser emitting at the wavelength λ_{REF}, the reference laser being adapted to be a reference to coherently detect a received downstream optical signal at wavelength λ_{DS}, and wherein the upstream laser and the reference laser are integrated on a unique chip so that the value |λ_{US} - λ_{REF}| is fixed.

Such optical transceiver enables an easy tunability of the upstream and reference lasers, thus of the upstream and downstream signals, at the same time, so as to improve the operability of optical networks such as quality and reliability of the communication, throughput and maintenance.

## Description

### Field of the Invention

The present invention relates to an optical transceiver easily tunable for optical access network.

### Background

In today's access networks, the use of several channels with temporal and/or wavelength multiplexing is problematic, as experienced in the development of New Generation Passive Optical Network phase 2 (NG-PON2) products.

This is particularly true for Optical Network Units (ONU), like residential gateways, where low cost and simple control methods are required.

An ONU comprises a transmitter and a receiver. Typical emitters or upstream lasers are tunable lasers that should be emitting in a narrow window (typically 25-40 GHz), and be able to be tuned to 4 to 8 channels spaced by 50 or 100 GHz, preferably in less than 25 ms. The emission window is between 1524 nm to 1544 nm.

The main difficulty in manufacturing such transmitter is to control the wavelength of the upstream laser. This setting is currently done by a pre-calibration of the upstream laser, typically a Distributed FeedBack laser (DFB) or an Electro-absorption Modulated Laser (EML). The ONU can only rely on the calibration of the upstream laser or on a possible error message sent by the central unit.

Regarding the downstream receivers, they have the same operating requirements except that their receiving window is typically between 1596 nm and 1603 nm.

Furthermore, in order to guarantee a good functioning of the transfer of the optical signals and therefore of the information, the emission or upstream laser requires a high power and the downstream receiver requires a good sensitivity. These requirements impact the costs like development costs, transceiver costs and power consumption.

Thus, there is a need for an easy tunable transceiver which guaranties or improves the operability of PON, and which would be low cost, and easy to implement.

### Summary

The present invention proposes firstly an optical transceiver and secondly an optical network which solve the prior art drawbacks.

In a first general optical transceiver embodiment, the optical transceiver for passive optical network comprises:
- an upstream laser emitting at the wavelength λ_{US}; and
- a receiver comprising a reference laser emitting at the wavelength λ_{REF}, the reference laser being adapted to be a reference to coherently detect a received downstream optical signal at wavelength λ_{DS},
wherein the upstream laser and the reference laser are integrated on a unique chip so that the value |λ_{US} - λ_{REF}| is fixed.

Specific features or embodiments of the optical transceiver, usable alone or in combination (provided that there is no conflict between the different elements) are:
- the upstream laser wavelength λ_{US} can be tuned based on the reference laser wavelength λ_{REF} or reciprocally the reference laser wavelength λ_{REF} can be tuned based on the upstream laser wavelength λ_{US};
- the upstream laser and the reference laser are made of the same material with two different Bragg gratings, the period of the Bragg gratings being adapted to fix the value |λ_{US} - λ_{REF}|,
- the upstream laser and the reference laser are made of two different materials with the same Bragg grating, the optical index of each material being adapted to fix the value |λ_{US} - λ_{REF}|,
- the upstream laser and the reference laser are tunable lasers each comprising a ring resonator, and wherein the value |λ_{US} - λ_{REF}| is fixed by adapting the optical index of the material on which each laser and corresponding ring resonator are when the characteristics of the ring resonators being identical;
- the upstream laser and the reference laser are tunable lasers each comprising a ring resonator, and wherein the value |λ_{US} - λ_{REF}| is fixed by adapting the characteristics of the ring resonators in the case when both lasers and corresponding ring resonators are built in the same material and / or
- the upstream laser and the reference laser comprise a Semiconductor Optical Amplifier, preferably a Reflective Semiconductor Optical Amplifier, the output optical signal of each laser being combined together by an Arrayed Waveguide Grating, the value |λ_{US} - λ_{REF}| being fixed by the choice of the Semiconductor Optical Amplifiers and of the Arrayed Waveguide Grating.

The present invention further relates to optical network comprising:
- a Central Station emitting a plurality of downstream optical signal λ_{DS_i}; and
- at least one optical transceiver as one previously described.

### Brief Description of the Drawings

Some embodiments of apparatus in accordance with embodiments of the present invention are now described, by way of example only, and with reference to the accompanying drawings, in which :
- Figure 1 schematically illustrates a classical Passive Optical Network (PON).
- Figure 2 schematically illustrates an optical transceiver according to a first embodiment of the present invention;
- Figure 3 schematically illustrates a first chip embodiment for an optical transceiver according to the present invention;
- Figure 4 schematically illustrates a second chip embodiment for an optical transceiver according to the present invention;
- Figure 5 schematically illustrates a third chip embodiment for an optical transceiver according to the present invention;
- Figure 6 schematically illustrates the gain curves and periodic mirror reflectivity curves of the third chip embodiment of Figure 5; and
- Figure 7 schematically illustrates a fourth chip embodiment for an optical transceiver according to the present invention.

### Description of Embodiments

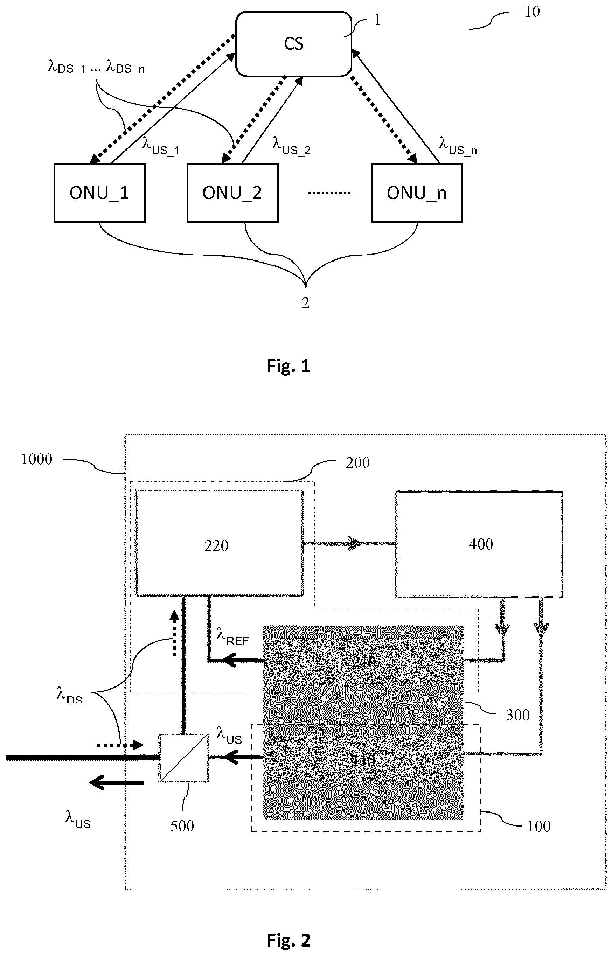

**Figure 1** illustrates a classical Passive Optical Network (PON) 10. The PON 10 comprises a Central Station (CS) 1 which is linked to multiple Optical Network Unit (ONU) 2, ONU_i, wherein i is an integer comprised between 1 and n, n corresponding to the number of users, like Internet subscribers for example.

The Central Station 1 sends a downstream signal which generally is a multiplex signal containing multiple wavelengths X_{DS_i}. Each wavelength X_{DS_i} corresponds to the downstream signal intended for the corresponding ONU_i, in response to an upstream signal λ_{US_i} which sends information requests.

Consequently and as already explained, to correctly receive the signal sent by the Central Station 1 and intended for the corresponding ONU_i 2, the receiver of each ONU_i 2 must be calibrated. This is usually done by using an accordable filter. Such calibration can be done at the factory during the manufacturing of the receiver or on site when the equipment is installed.

Due to the aging of the equipment, the calibration of the receiver must be done regularly, as well as when the filter is changed.

Depending on the network load, the Central Station 1 may change one or more downstream wavelengths to optimize the throughput. Thus the receivers of the ONU_i 2 concerned about the change must adapt their receiving or sensitive wavelength range consequently. The couple formed by the transmitter and the receiver of an ONU 2 been linked, the upstream laser must also adapt its wavelength λ_{US_i} consequently.

The reciprocal situation may also appear if a communicating channel is already attributed to another user or ONU 2.

As previously described, to guaranty a good functioning of the transfer of the optical signals and therefore of the information, the emission or upstream laser requires a high power and the downstream receiver requires a good sensitivity.

To overcome these drawbacks, the present invention proposes an optical transceiver for Passive Optical Network (PON).

**Figure 2** illustrates a first and general embodiment, in this embodiment, the optical transceiver 1000 comprises:
- a transmitter 100 comprising an upstream laser 110 emitting at the wavelength λ_{US}; and
- a receiver 200 comprising a reference laser 210 emitting at the wavelength λ_{REF}, the reference laser 210 being adapted to be a reference to coherently detect a received downstream optical signal at wavelength λ_{DS}.

The receiver 200 comprises a simplified coherent receivers 220, which receives a downstream signal coming from a central station for example, and having a wavelength λ_{DS}, and the signal of reference laser 210 in order to apply a coherent detection and detect the information sent by the central station. For such coherent detection, the wavelength λ_{REF} of the reference laser 210 must be at the wavelength λ_{DS} of the downstream signal.

The principle of a coherent detection is to make the downstream signal interfere with the reference laser 210 at a same wavelength so that Analogical-to-Digital converters can measure data based on the phase and amplitude of the downstream signal.

In the European project COCONUT [R1], it has been demonstrated that coherent detection increases the optical budget of a PON by at least 10 dB compared to direct detection.

To combine the downstream signal λ_{DS} coming from the Central Station, typically via an optical fiber, and thus to inject the upstream signal λ_{US} into this same optical fiber, the optical transmitter can include an optical beam splitter 500. The optical beam splitter 500 sends the downstream signal λ_{DS} into the simplified coherent receiver 220, which will coherently detects the information contained in the downstream signal λ_{DS} with the use of the reference laser λ_{REF}, and let the upstream signal λ_{US} go out of the transmitter 100 to be injected into the optical fiber.

The particularity of this embodiment is that the upstream laser 110 and the reference laser 210 are integrated on a unique chip 300 so that the value |λ_{US} - λ_{REF}| is fixed.

Such embodiment enables to easily control the tunability of the upstream and of the reference lasers at the same time so as to improve the operability of the PON.

In fact, when the Central Station changes the downstream wavelength λ_{DS}, the simplified coherent receiver 220 can detect that the wavelength λ_{DS} has changed and send a message so as to modify consequently the wavelength of the reference laser, λ_{REF}, and the wavelength of the upstream laser λ_{US}, so as to keep connected and communicate with the Central Station.

Advantageously, this operation can be done by control electronics 400 that receive the message coming for the simplified coherent receiver 220 and send an adapted order to a local heater placed on the surface of the chip for example.

So the wavelengths of the reference laser λ_{REF} and of the upstream laser λ_{US} will change keeping the same fixed value |λ_{US} - X_{REF}|.

Advantageously, the upstream laser wavelength λ_{US} can be tuned based on the reference laser wavelength λ_{REF} or reciprocally the reference laser wavelength λ_{REF} can be tuned based on the upstream laser λ_{US}.

In terms of maintenance, if there is a problem in the optical transceiver of a user, there is only one chip that needs to be change and which is a low-cost component.

Such a chip 300 can be realized according to different embodiments, as some examples described below.

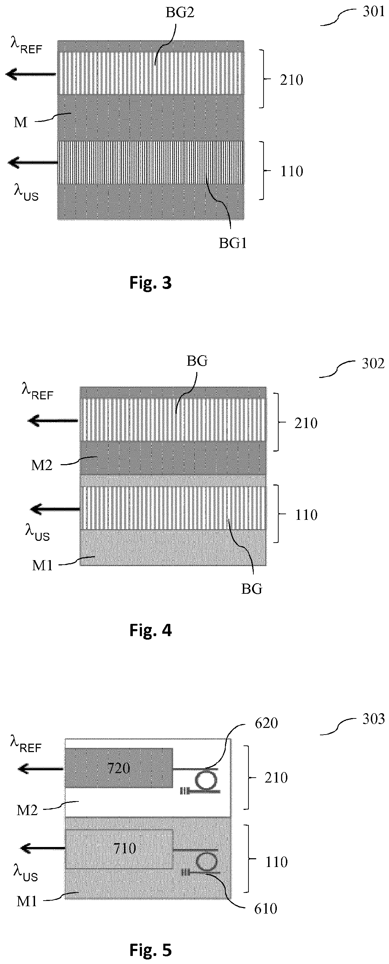

In the chip 301 illustrated **Figure 3****,** the upstream laser 110 and the reference laser 210 are made of the same material M with two different Bragg gratings BG1, BG2. The period of the Bragg Grating BG1 determines the wavelength λ_{US} of the upstream laser and the period of the Bragg Grating BG2 determines the wavelength λ_{REF} of the reference laser Thus, the period of the Bragg gratings BG1 and BG2 must be adapted to fix the value |λ_{US} - X_{REF}|.

**Figure 4** illustrates another example of such a chip 302. In this embodiment, the upstream laser 110 and the reference laser 210 are made of two different materials M1 and M2 with the same Bragg gratings BG. In this case, it is the respective optical indices n1 and n2 of the material M1 and M2 that determine the wavelength λ_{US} of the upstream laser 110 and λ_{REF} of the reference laser 210. Thus, these optical indices n1 and n2 must be adapted to fix the value |λ_{US} - X_{REF}|.

In the chip 303 embodiment illustrated in **Figure 5****,** the upstream laser 110 and the reference laser 210 are tunable lasers. Each comprise a ring resonator 610 and 620 and for example a Semi-Reflective Optical Amplifier (RSOA) or a gain medium 710 and 720. The value |λ_{US} - λ_{REF}| can be fixed by adapting the optical index of the material M1, M2 on which each laser and corresponding ring resonator 610, 620 are in the case wherein the characteristics (for example the diameter) of the ring resonators are identical (and also the gain medium 710 and 720). Or, the value |λ_{US} - λ_{REF}| can be fixed by adapting the characteristics (for example the diameter) of the ring resonators 610 and 620 in the case where the two lasers and corresponding ring resonators 610 and 620 (and thus the gain medium 710 and 710 too) are built in the same material (M1=M2).

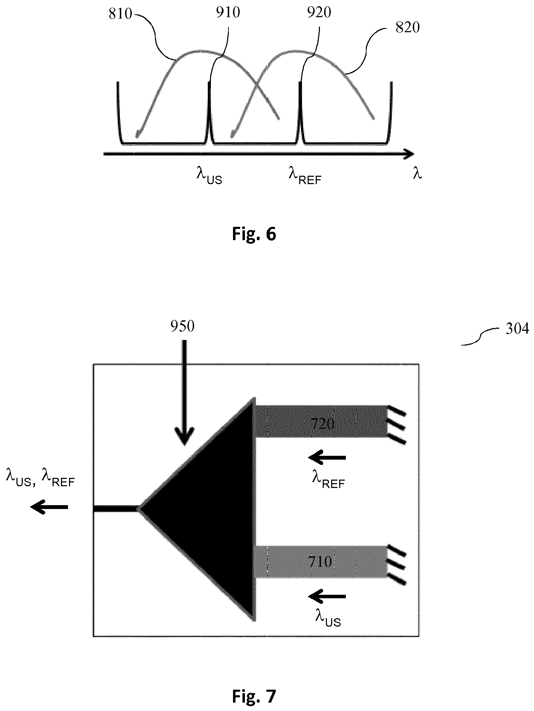

**Figure 6** illustrates the gain curves 810 and 820 of the gain medium 710 and 720 of respectively the upstream laser 110 and the reference laser 220. It also illustrates the mirror reflectivity curve 910 and 920 of the RSOA 710 and 720 of respectively the upstream laser 110 and the reference laser 220.

In reference to **Figure 7****,** the upstream laser 110 and the reference laser 210 comprise a Semiconductor Optical Amplifier (SOA), preferably a Reflective Semiconductor Optical Amplifier (RSOA) 710 and 720 as described before. Each output optical signal of each laser is combined together by an Arrayed Waveguide Grating (AWG), or an optical coupler 950. In such an embodiment of the chip 304, the value |λ_{US} - λ_{REF}| can be fixed by the choice of the SOA/RSOA 710, 720, and/or of the AWG 950.

In this case, the beam splitter 500 of the optical transceiver 1000 will have to be adapted so that the upstream signal λ_{US} could go out and the reference laser λ_{REF} could be send to the simplified coherent receiver 220.

The present invention further relates to an optical network similar to the one described in **Figure 1** comprising a Central Station 1 emitting a plurality of downstream optical signal λ_{DS_i} and at least one optical transceiver 1000 as previously described which would correspond to one ONU_i 2 of the **Figure 1****.**

The invention has many advantages. It offers a lost cost transceiver, easy to manufacture and to maintain. The coherent detection of the downstream signal increases the optical budget of the optical network. The tunability and reliability of the operating network is guaranteed by the chip which comprises the upstream and the reference laser which properties are linked together fixing the value and thus fixing the couple enabling to the communication between a Central Station and the optical transceiver. Such single chip is easy, low cost to produce and easy to implement in a transceiver.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

### REFERENCES LIST

[R1] Official website of COst-effective CohereNt Ultra-dense-WDM-PON for lambda-To-the-user access (COCONUT) project: http://www.ict-coconut.eu/

## Claims

1. An optical transceiver (1000) for passive optical network comprising:
• an upstream laser (110) emitting at the wavelength λ_{US}; and
• a receiver (200) comprising a reference laser (210) emitting at the wavelength λ_{REF}, the reference laser (210) being adapted to be a reference to coherently detect a received downstream optical signal at wavelength λ_{DS},
**characterized in that** the upstream laser (110) and the reference laser (210) are integrated on a unique chip (300) so that the value |λ_{US} - λ_{REF}| is fixed.

2. The optical transceiver (1000) according to claim 1 wherein the upstream laser (110) wavelength λ_{US} can be tuned based on the reference laser (210) wavelength λ_{REF} or reciprocally the reference laser (210) wavelength λ_{REF} can be tuned based on the upstream laser (110) wavelength λ_{US}.

3. The optical transceiver (1000) according to claim 1 or 2 wherein the upstream laser (110) and the reference laser (210) are made of the same material (M) with two different Bragg gratings (BG1, BG2), the period of the Bragg gratings (BG1, BG2) being adapted to fix the value |λ_{US} - X_{REF}|.

4. The optical transceiver (1000) according to claim 1 or 2 wherein the upstream laser (110) and the reference laser (210) are made of two different materials (M1, M2) with the same Bragg grating (BG), the optical index of each material (M1, M2) being adapted to fix the value |λ_{US} - λ_{REF}|.

5. The optical transceiver (1000) according to claim 1 or 2 wherein the upstream laser (110) and the reference laser (210) are tunable lasers each comprising a ring resonator (610, 620), and wherein the value |λ_{US} - λ_{REF}| is fixed by adapting the optical index of the material (M1, M2) on which each laser (110, 210) and corresponding ring resonator (610, 620) are when the characteristics of the ring resonators (610, 620) are identical.

6. The optical transceiver (1000) according to claim 1 or 2 wherein the upstream laser (110) and the reference laser (210) are tunable lasers each comprising a ring resonator (610, 620), and wherein the value |λ_{US} - λ_{REF}| is fixed by adapting the characteristics of the ring resonators (610, 620) in the case when both lasers (110, 210) and corresponding ring resonators (610, 620) are built in the same material (M1=M2).

7. The optical transceiver (1000) according to claim 1 or 2 wherein the upstream laser (110) and the reference laser (210) comprise a Semiconductor Optical Amplifier (710, 720), the output optical signal of each laser (110, 210) being combined together by an Arrayed Waveguide Grating (950), the value |λ_{US} - λ_{REF}| being fixed by the choice of the Semiconductor Optical Amplifiers (710, 720) and of the Arrayed Waveguide Grating (950).

8. An optical network comprising:
- a Central Station emitting a plurality of downstream optical signal |λ_{DS_i}; and
- at least one optical transceiver (100) as one of claim in claims 1-7.
